# EUROPÄISCHE PATENTSCHRIFT

(11) **EP 0 582 251 B1**
(45) Veröffentlichungstag und Bekanntmachung des Hinweises auf die Patenterteilung: **16.06.1999**
(21) Anmeldenummer: 93112356.6
(22) Anmeldetag: 02.08.1993
(51) Int. Cl.: G03F 7/20

(54) **Laserbelichtungsgerät für bildmässig zu belichtende Druckformen**
Laser exposure apparatus for printing plates
Appareil d'exposition au laser pour plaques d'impression

(30) Priorität: 05.08.1992 DE 4225828
(43) Veröffentlichungstag der Anmeldung: 09.02.1994
(73) Patentinhaber: Agfa-Gevaert AG, 51373 Leverkusen (DE)
(72) Erfinder: Zertani, Rudolf, Dr., D-55234 Bechtolsheim (DE); Krämer, Norbert, D-65321 Heidenrod (DE); Haberhauer, Helmuth, D-65232 Taunusstein (DE)

(56) Entgegenhaltungen:
- EP-A- 0 456 355
- DE-U- 9 210 460
- US-A- 4 864 326
- PATENT ABSTRACTS OF JAPAN Bd. 9, Nr. 273 (P-401) 30 Oktober 1985 & JP-A-60 117 268 (MITA KOGYO KK) 24 Juni 1985

## Beschreibung

Die Erfindung betrifft ein Laserbelichtungsgerät für bildmäßig zu belichtende Druckformen, mit einem Laser, Strahlteiler, Modulator, Strahlaufweiter, Polygonspiegel, Scanner-Linse, Referenzmaske, Umlenkspiegel und Zusatzbelichtungseinrichtung.

Ein derartiges Laserbelichtungsgerät ist aus dem Dokument JP 60/117268 bekannt, bei dem ein Modulator die Beugungsrichtung des Laserlichts entsprechend einem Druckcode steuert, der von einem Generator 5 ausgegeben wird und nur gebeugtes Licht in einer vorgegebenen Richtung auf einen Polygonspiegel gelenkt wird. Der Polygonspiegel rotiert, so daß das Laserlicht die fotoempfindliche Oberfläche einer Walze über die Breite der Walze abtastet. Als Zusatzbelichtung ist eine langwellige LED vorgesehen, die Licht für die Vorbelichtung der fotoempfindlichen Oberfläche der Walze liefert. Das Licht der LED wird gleichfalls über den Polygonspiegel auf die fotoempfindliche Walzenoberfläche gelenkt. Dadurch wird eine Belichtung erreicht, bei der die LED-Anordnung nicht durch Toner kontaminiert wird, so daß die Belichtungsanordnung eine Langzeitstabilität ohne Wartung besitzt.

Aus der DE-B 12 14 085 (US-PS 3,144,331) ist es bekannt, zur Wiederherstellung der Empfindlichkeit fotopolymerisierbare Aufzeichnungsmaterialien, die als lichtempfindliche Schicht auf einem Druckplattenträger aufgetragen sind und deren Empfindlichkeit durch Absorption von molekularem Sauerstoff nachgelassen hat, mit 70 bis 98 % der Strahlungsmenge einer aktinischen Strahlung zu belichten, die bei gleichmäßigen Auftreffen zur Einleitung einer Fotopolymerisation notwendig wäre. Die Belichtung erfolgt durch den beispielsweise transparenten Druckplattenträger hindurch, wobei eine aktinische Strahlung mit einer solchen Wellenlänge verwendet wird, daß nur 10 bis 70 % der Strahlung von der fotopolymerisierbaren Schicht absorbiert werden. Bei diesem Verfahren wird im Prinzip einmal diffus und einmal bildmäßig belichtet. Die Diffus- bzw. Vorbelichtung erfolgt mit geringerer Intensität, nämlich mit 70 bis 98 % der Strahlungsintensität, die zum Erreichen der vollen Belichtungswirkung erforderlich ist. An diese Vorbelichtung schließt dann die bildmäßige Belichtung mit voller Strahlungsintensität an.

In der US-PS 4,298,803 ist ein Verfahren beschrieben, bei dem eine Fotoresistschicht mit einer Intensität vorbelichtet wird, die niedriger als die kritische Belichtungsintensität ist, bei der der Fotoresist an den belichteten Stellen weitgehend weggelöst werden kann. Nach dieser Vorbelichtung erfolgt die bildmäßige Belichtung der Fotoresistschicht. Die Reihenfolge der beiden Belichtungen kann vertauscht werden. In beiden Fällen wird die Lichtempfindlichkeit der Fotoresistschicht verbessert, wodurch die Bearbeitungszeit stark verkürzt wird. Bei der für dieses Verfahren eingesetzten Vorrichtung können sowohl die bildmäßige Belichtung als auch die Vor- bzw. Nachbelichtung des Fotoresists mittels eines Elektronenstrahls, einer UV- oder Röntgenstrahlenquelle erfolgen.

Aus der US-PS 4,716,097 ist gleichfalls ein Verfahren bekannt, bei dem eine fotopolymere Schicht, die einen Farbstoff enthält, zuerst mit Licht einer Wellenlänge oberhalb von 400 nm und einer Intensität von mindestens 1500 Lumen/m² diffus und danach bildmäßig belichtet wird.

In der deutschen Offenlegungsschrift DE-A 24 12 571 ist ein Verfahren zum Aushärten einer durch Licht härtbaren Polymerschicht einer Druckplatte beschrieben, bei dem zuerst diffus für kurze Zeit belichtet und danach bildmäßig so lange belichtet wird, bis die Polymerschicht praktisch vollständig in den belichteten Bereichen ausgehärtet ist. Die diffuse Belichtungsdauer beträgt maximal 90 % der Zeit, innerhalb welcher die vollständige Aushärtung der Polymerschicht bei gleicher Intensität der Strahlung sowohl für die Vorbelichtung als auch für die bildmäßige Belichtung erfolgt.

Aufgabe der Erfindung ist es, ein Laserbelichtungsgerät für bildmäßig zu belichtetende Druckformen so zu gestalten, daß die Strahlungsempfindlichkeit der fotopolymerisierbaren Aufzeichnungsschicht der Druckform erhöht wird und der Informationsverlust kleingehalten werden.

Diese Aufgabe wird erfindungsgemäß in der Weise durch ein Laserbelichtungsgerät der eingangs beschriebenen Art gelöst, daß die Zusatzbelichtungseinrichtung in einem abgeschlossenen Gehäuse zu einer der beiden Seiten eines Laser-Schreibstrahls des Lasers angeordnet ist und daß eine LED-Zeilenanordnung die Zusatzbelichtung liefert, die durch eine Scheibe in der Unterseite des Gehäuses austritt und auf die durchlaufende Druckform auftrifft.

In Ausgestaltung der Erfindung ist die Zusatzbelichtungseinrichtung in Bewegungsrichtung der Druckform durch das Laserbelichtungsgerät hindurch vor dem Laser-Schreibstrahl angebracht.

Bei dieser Anordnung erfolgt eine Vorbelichtung vor der eigentlichen Laserbelichtung der Druckform. Ebenso kann die Erfindung in einer Weise ausgestaltet sein, daß die Zusatzbelichtungseinrichtung in Bewegungsrichtung der Druckform durch das Laserbelichtungsgerät hindurch nach dem Laser-Schreibstrahl angeordnet ist, um eine Nachbelichtung der laserbelichteten Druckform vorzunehmen. In Weiterbildung der Erfindung ist je eine Zusatzbelichtungseinrichtung vor und nach dem Laser-Schreibstrahl vorhanden und ist nur jeweils eine der Zusatzbelichtungseinrichtungen während des Durchlaufs einer Druckform durch das Laserbelichtungsgerät eingeschaltet.

Die weitere Ausgestaltung der Erfindung ergibt sich aus den Merkmalen der Patentansprüche 5 bis 15.

Mit dem Laserbelichtungsgerät nach der Erfindung werden fotopolymerbeschichtete Druckformen, insbesondere hochlichtempfindliche Laserplatten, belichtet, wobei durch die Vor- oder Nachbelichtung mit Licht sehr geringer und sehr gleichmäßiger Intensität die Lichtempfindlichkeit der so behandelten Druckformen erheblich gesteigert werden kann. Hierzu werden die unbelichteten Druckformen, die beispielsweise nach erfolgter Vorbelichtung von einem Laser mit einer Wellenlänge von 488 nm oder 514 nm belichtet werden, mit Hilfe der Zusatzbelichtungseinrichtung mit Licht einer Wellenlänge = 565 ± 20 nm mit sehr geringer Intensität vorbelichtet. Von Vorteil ist bei dieser Zusatzbelichtungseinrichtung, daß die Leuchtstärke ihrer Strahlungsquelle in sehr weiten Grenzen einstellbar ist.

Die Erfindung wird im folgenden anhand der Zeichnung näher erläutert. Es zeigen:
- Fig. 1: eine schematische perspektivische Darstellung der Haupt- bzw. Laserbelichtung einer Druckform in einem Laserbelichtungsgerät nach der Erfindung,
- Fig. 2: eine schematische Schnittansicht eines Laserbelichtungsgeräts mit Zusatzbelichtungseinrichtungen für die Vor- oder Nachbelichtung der Druckform, und
- Fig. 3 bis 5: eine Seitenansicht und Draufsicht sowie die Schaltung der Strahlungsquelle einer Zusatzbelichtungseinrichtung.

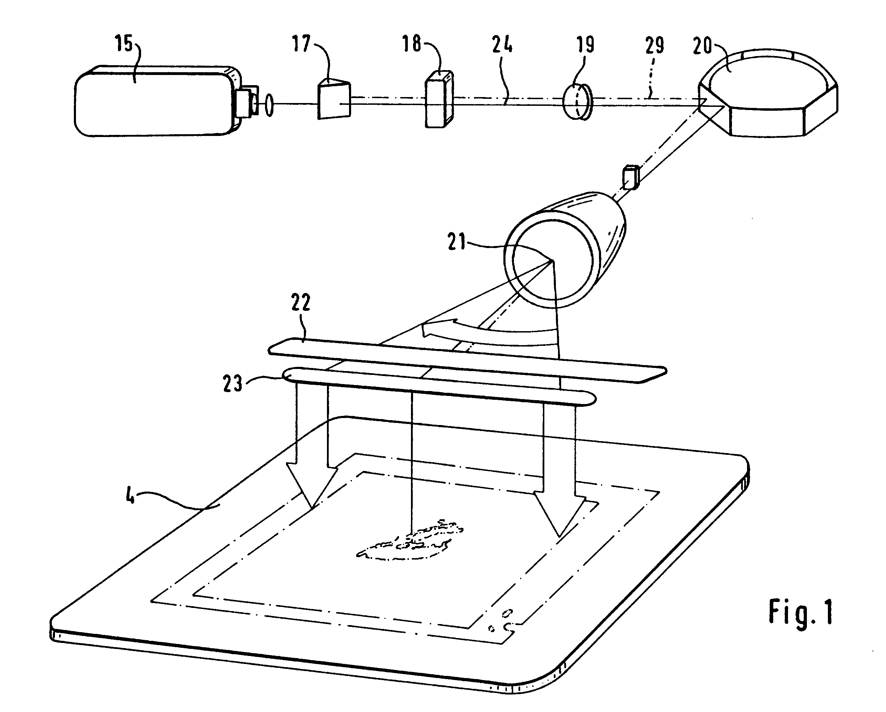

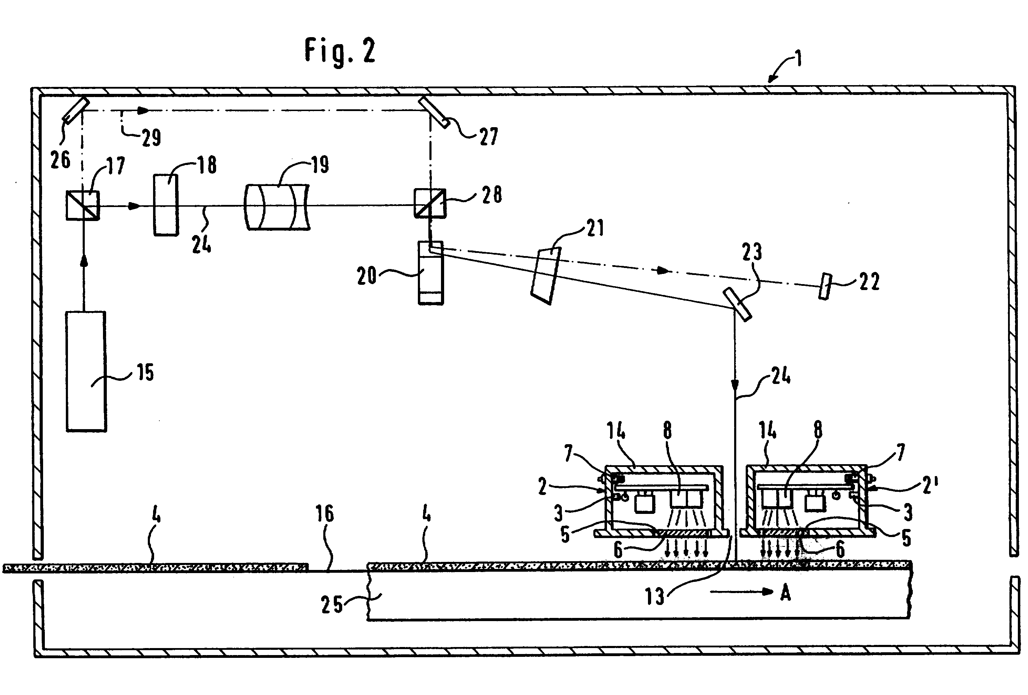

Die in Fig. 1 in schematischer Perspektivdarstellung gezeigten Elemente für eine Laserbelichtung einer Druckform 4, beispielsweise einer Negativ-Laserplatte Ozasol N90 der Fa. HOECHST Aktiengesellschaft, Frankfurt/Main, Deutschland, umfassen einen Laser 15, einen Strahlteiler 17, einen Modulator 18 für den reflektierten Laserstrahl bzw. Schreibstrahl 24, einen Strahlaufweiter 19, einen rotierenden Polygonspiegel 20, auf dem der Schreibstrahl 24 und der nicht reflektierte Laserstrahl bzw. Referenzstrahl 29 nach dem Zusammenführen auftreffen, eine Referenzmaske 22 und einen Umlenkspiegel 23, der den Schreibstrahl auf die Druckform 4 lenkt. Das Schema einer derartigen Laserbelichtung findet Anwendung für die Hauptbelichtung einer Druckform 4 in einem Laserbelichtungsgerät 1, wie es schematisch in Fig. 2 in Schnittansicht gezeigt ist. Die gleichen Elemente wie in Fig. 1 sind mit den gleichen Bezugszahlen in Fig. 2 belegt. Der Laserstrahl des Laser 15 wird im Strahlteiler 17 in den reflektierten Laserstrahl bzw. Schreibstrahl 24, in vollen Linien gezeichnet, und in den nicht reflektierten Laserstrahl bzw. Referenzstrahl 29, strichpunktiert gezeichnet, aufgeteilt. Der Schreibstrahl 24 durchläuft den Modulator 18, der entsprechend einem Steuersignal den Schreibstrahl 24 hindurchläßt oder sperrt. Das Steuersignal wird von einem Datenspeicher geliefert, in dem binär die Information des wiederzugebenden Bildes gespeichert ist. Anschließend durchläuft der Schreibstrahl 24 einen Strahlaufweiter 19, bestehend aus einem System zweier gegeneinander verfahrbarer Linsen zur Fokussierung des Schreibstrahles 24. Nach dem Strahlaufweiter 19 trifft der Schreibstrahl auf einen Strahlkombinierer 28 auf und wird durch diesen mit dem Referenzstrahl 29 zusammengeführt, der nach dem Durchstrahlen des Strahlteilers 17 durch Umlenkspiegel 26, 27 auf den Strahlkombinierer 28 gelenkt wird. Dieser leitet Schreib- und Referenzstrahl 24, 29 auf den Polygonspiegel 20, der durch seine Rotation den Schreibstrahl 24 über die Breite der Druckform 4 führt. Nach dem Polygonspiegel 20 durchlaufen die beiden Strahlen 24, 29 eine Scanner- oder Abtastlinse 21, die dafür sorgt, daß die durch den Polygonspiegel verursachte bogenförmige Krümmung der Strahlen 24, 29 ausgeglichen wird, so daß die Strahlen geradlinig nach dem Passieren der Abtastlinse weiterlaufen. Der Schreibstrahl 24 trifft nach der Abtastlinse 21 auf den Umlenkspiegel 23 auf, der ihn senkrecht nach unten, durch einen Belichtungsschlitz 13 hindurch, auf die in Pfeilrichtung A durch das Laserbelichtungsgerät 1 hindurchlaufende Druckform 4 lenkt, die durch den Schreibstrahl 24 belichtet wird. Der Referenzstrahl 29 trifft auf die Referenzmaske 22 auf, die aus einer Glasplatte mit Strichlinienmuster, Diffusorscheibe und einer Reihe von Dioden besteht. Die Diffusorscheibe vergleichmäßigt die Strahlungsintensität des das Strichlinienmuster durchstrahlenden Referenzstrahls 29, der auf eine der Dioden auftrifft, die ein entsprechendes Synchronisationssignal an den Modulator 18 liefert, um dessen Öffnen und Schließen mit dem jeweils anliegenden Steuersignal aus dem zuvor erwähnten Datenspeicher zu synchronisieren.

Jede der in Fig. 2 im Schnitt schematisch dargestellten Zusatzbelichtungseinrichtungen 2, 2' weist ein Gehäuse 14 auf, das nach unten hin durch eine Scheibe abgeschlossen ist, bei der es sich um eine Lichtstreuscheibe 6 handelt, die in einer Gehäuseöffnung 5 der Gehäuseunterseite angebracht ist. Druckformen 4, von denen zwei in Fig. 2 schematisch gezeigt sind, laufen entlang einer Transportbahn 16 in Pfeilrichtung A an den Zusatzbelichtungseinrichtungen 2, 2' und unterhalb von diesen vorbei. Im Gehäuse 14 ist eine elektronische Regelung 7 für eine Strahlungsquelle in Gestalt einer LED-Zeilenanordnung 8 untergebracht. Die Leuchtstärke der Strahlungsquelle mißt ein Sensor 3, der auf der Abstrahlseite der LED-Zeilenanordnung befestigt ist.

In Fig. 2 sind zwei Zusatzbelichtungseinrichtungen 2, 2' für die Vor- und die Nachbelichtung der Druckform 4 zu beiden Seiten des Belichtungsschlitzes 13 angeordnet. Selbstverständlich kann das Laserbelichtungsgerät 1 auch nur mit einer der beiden Zusatzbelichtungseinrichtungen 2, 2' entweder nur für die Vorbelichtung oder nur für die Nachbelichtung ausgerüstet sein. Durch die Vorbelichtung wird die fotopolymerisierbare Aufzeichnungsschicht der Druckform 4 lichtempfindlicher, da sie bei geringerem Potential als bei der Hauptbelichtung zu vernetzen beginnt. Der Informationsverlust, insbesondere bei schmalen Informationsbereichen, den sogenannten Spitzpunktinformationen, wird durch die beginnende Vernetzung während der Vorbelichtung kleingehalten.

Erfolgt als Zweitbelichtung eine Nachbelichtung, so wird die Lichtempfindlichkeit der Druckformen im allgemeinen nicht so stark wie im Falle der Vorbelichtung erhöht. Eine mögliche Erklärung könnte sein, daß die Vernetzung im Vergleich zur Vorbelichtung geringer bleibt, da weniger Radikale, wegen gleichbleibender Sauerstoffkonzentration, gebildet werden. Es gilt jedoch sowohl für die Vorals auch für die Nachbelichtung, daß die Lichtempfindlichkeit der Druckform 4 gegenüber der reinen Hauptbelichtung durch einen Laserstrahl erhöht wird.

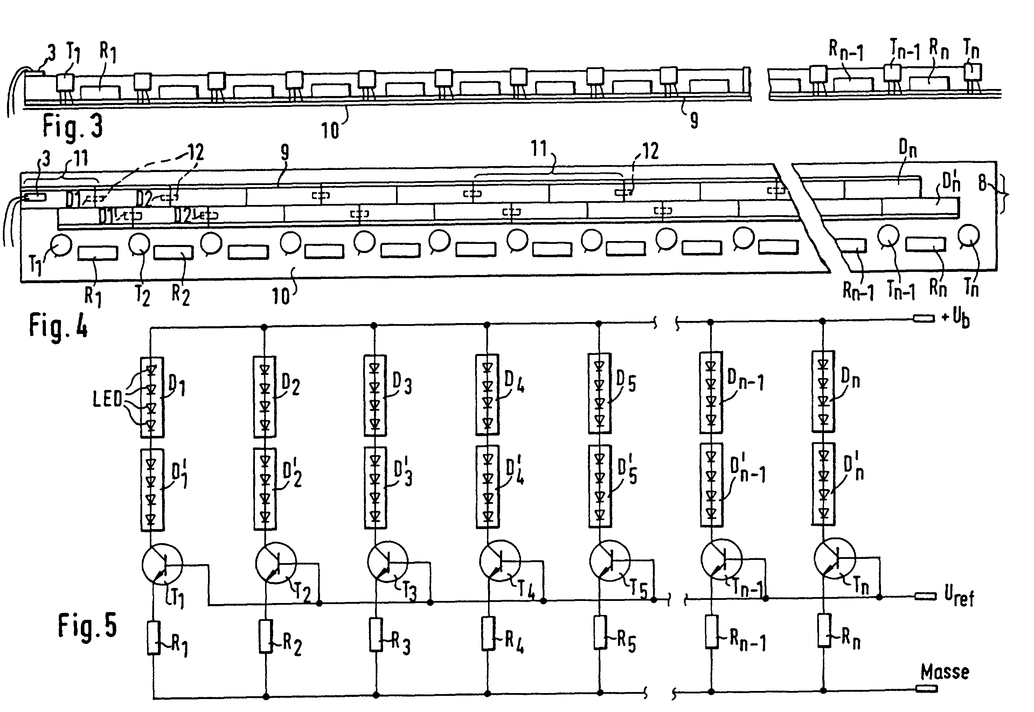

Die LED-Zeilenanordnung 8 dient zusammen mit der Lichtstreuscheibe der ganzflächigen, diffusen Belichtung der Druckform 4. Diese LED-Zeilenanordnung 8 besteht zumindest aus zwei zueinander versetzten Reihen von LED-Modulen D₁, D₂, ... Dₙ und D₁', D₂' ... Dₙ', wie die Figuren 4 und 5 zeigen, und befindet sich in einem geschlossenen Gehäuse 14 der Zusatzbelichtungseinrichtung 2. Nach unten hin, in Richtung der Transportbahn 16 für die Druckformen, weist das Gehäuse 14 die Belichtungsöffnung 5 auf, die von der Lichtstreuscheibe 6 abgedeckt ist.

Das einzelne Modul D₁, ... Dₙ, D₁' ... Dₙ' besteht im allgemeinen aus vier Leuchtdioden LED, die, wie in Figur 5 gezeigt, in Reihe geschaltet sind. Zwei Module D₁, D₁'; D₂, D₂' ... Dₙ, Dₙ' sind jeweils in Reihe geschaltet und werden von einer nicht dargestellten Stromquelle mit einer Referenzspannung U_{ref} gespeist. Je zwei in Reihe geschaltete Module werden von einem Stromkreis aus Transistor Tᵢ und strombegrenzendem Widerstand Rᵢ, mit i = 1, 2, ... n, gesteuert. Der Widerstand Rᵢ kann ein Festwiderstand oder ein regelbarer Widerstand in Gestalt eines Potentiometers sein. Die Stromquelle beaufschlagt die Basen sämtlicher Transistoren Tᵢ, die parallel geschaltet sind, mit der Referenzspannung U_{ref}. Die gleichfalls parallel geschalteten Widerstände Rᵢ begrenzen die Emitterströme der Transistoren Tᵢ. Die Referenzspannung U_{ref} ist eine Gleichspannung im Bereich von 0 bis 3 V, es fließt dann ein Basis-Emitterstrom I_{BE} von 0 bis 30 mA, oder eine Rechteckspannung im Bereich von 0 bis 6 V, mit einem Basis-Emitterstrom I_{BE} von 0 bis 60 mA, mit einem Tastverhältnis von 1:2. Die Stromquelle der Referenzspannung U_{ref} liefert einen Strom in der Größenordnung von 100 mA und kann z.B. ein D/A-Wandler mit einer Pufferstufe oder eine separate Steuerschaltung sein.

Die effektive Leuchtstärke der LED-Zeilenanordnung 8 wird durch den Sensor 3 gemessen. Damit eine gleichmäßige Ausleuchtung über die gesamte Breite der LED-Zeilenanordnung 8 erhalten wird, werden LED-Module aus einer Fertigung verwendet. Treten dennoch Helligkeitsunterschiede zwischen den einzelnen Modulen auf, so werden sie durch Verändern des zugehörigen Widerstandes Rᵢ ausgeglichen.

Die LED-Module D₁, D₁', ... Dₙ, Dₙ' sind auf Segmenten 11 angeordnet, die gleiche oder unterschiedliche Längen haben und werden mittels Steckkontakten 12 zu einer Platine 9, wie aus Fig. 4 ersichtlich, zusammengesteckt. Auf dem einzelnen Segment 11 kann ein einzelnes oder zwei bis vier Module angebracht sein. Die Steckkontakte 12 sind in Fig. 4 gestrichelt angedeutet. Je ein Segment 11 mit einem und mit zwei Modulen der oberen Reihe der LED-Zeilenanordnung 8 ist durch eine geschwungene Klammer markiert. Die zusammengesteckte Platine 9 ist auf einer Grundplatine 10 befestigt, auf der auch die Transistoren Tᵢ und Widerstände Rᵢ angeordnet sind. Da die einzelnen Segmente 11 unterschiedliche Längen haben können, ist die Reihenlänge an die Breite der zu belichtenden Druckform anpaßbar. Durch die segmentierte Bauweise der LED-Zeilenanordnung 8 ist bei einem Ausfall von einem oder mehreren LED-Modulen ein schneller Austausch möglich, da die funktionierenden Bauteile nicht ausgebaut werden müssen. Bei der Alterung der LED tritt keine spektrale Veränderung, d.h. keine Verschiebung des ausgesandten Wellenlängenbereiches auf. Durch die Stromregelung der LED-Module ist eine gleichmäßige Leuchtleistung über die volle Länge der LED-Zeilenanordnung 8 einstellbar, die mit Niederspannung betrieben wird.

Die Beleuchtungsstärke der LED-Zahlenanordnung 8 der Zusatzbelichtungseinrichtungen 2, 2' ist zur genauen Dosierung der auf die Druckform 4 applizierten Lichtmenge elektronisch stufenlos zwischen 0 % und 100 % der maximalen Beleuchtungsstärke regelbar. Die Anzeige der Beleuchtungsstärke dieser LED-Zeilenanordnung 8 erfolgt digital, wobei zur Messung der Beleuchtungsstärke der Sensor 3 im Inneren des Gehäuses angebracht ist. Die Geschlossenheit des Gehäuses verhindert das Auftreten von äußeren Störstrahlungen, die die Messung der Beleuchtungsstärke mittels des Sensors 3 in unerwünschter Weise beeinträchtigen könnten.

Die Einstellung der Beleuchtungsstärke der LED-Zeilenanordnung 8 erfolgt durch die elektronische Regelung 7, die oberhalb der LED-Zeilenanordnung 8 schematisch dargestellt ist.

Die spektrale Verteilung der LED-Zeilenanordnung 8 liegt im Wellenlängenbereich von 565 ± 20 nm.

Der Sensor 3 zur Messung der Beleuchtungsstärke ist üblicherweise eine Fotodiode, die sich im Gehäuse 14 der Zusatzbelichtungseinrichtung 2 befindet und dadurch von jeglicher Störstrahlung, wie beispielsweise in das Gehäuse 14 einfallendes Tageslicht, abgeschirmt ist. Zweckmäßigerweise ist die Fotodiode oberhalb der Platine 9 angebracht (vgl. Fig. 3).

Mit den Zusatzbelichtungseinrichtungen 2, 2' werden die Vorteile erzielt, daß die LED-Zeilenanordnung 8 über die Arbeitsbreite der Druckform 4 eine sehr gleichmäßige Belichtungsstärke erzeugt, und die Belichtungsintensität der LED-Module bzw. der LED-Zeilenanordnung 8 stufenlos geregelt werden kann. Die Ergebnisse der Belichtung für unterschiedliche Belichtungsintensitäten sind stets reproduzierbar. Eine Alterung der LED-Module verursacht keine spektrale Verschiebung, so daß die ausgesandte Wellenlänge weitgehend konstant bleibt. Weitere Vorteile der Zusatzbelichtungseinrichtungen 2, 2' bestehen darin, daß keine Störstrahlungen im Bereich der Zusatzbelichtungseinrichtungen auftreten können, daß die LED-Zeilenanordnung 8 in ihrer Länge beliebig konfigurierbar ist und in ihrer vollen Länge zum Belichten genutzt werden kann und daß sie mit Niederspannung betrieben und im Bereich von 0 bis 100 % ihrer Leuchtleistung einstellbar ist.

## Patentansprüche

1. Laserbelichtungsgerät für bildmäßig zu belichtende Druckformen, mit einem Laser, Strahlteiler, Modulator (18), Strahlaufweiter (19), Polygonspiegel (20), Scanner-Linse (21), Referenzmaske (22) und Umlenkspiegel (23), wobei zumindest eine Zusatzbelichtungseinrichtung (2,2') in dem Laserbelichtungsgerät (1) vorhanden ist, dadurch gekennzeichnet, daß diese Zusatzbelichtungseinrichtung in einem abgeschlossenen Gehäuse (14) zu einer der beiden Seiten eines Laser-Schreibstrahls (24) des Lasers (15) angeordnet ist und daß eine LED-Zeilenanordnung (8) die Zusatzbelichtung liefert, die durch eine Scheibe (6) in der Unterseite des Gehäuses (14) austritt und auf die durchlaufende Druckform (4) auftriftt.

2. Laserbelichtungsgerät nach Anspruch 1, dadurch gekennzeichnet, daß die Zusatzbelichtungseinrichtung (2) in Bewegungsrichtung der Druckform (4) durch das Laserbelichtungsgerät hindurch vor dem Laser-Schreibstrahl (24) angebracht ist.

3. Laserbelichtungsgerät nach Anspruch 1, dadurch gekennzeichnet, daß die Zusatzbelichtungseinrichtung (2') in Bewegungsrichtung der Druckform (4) durch das Laserbelichtungsgerät hindurch nach dem Laser-Schreibstrahl (24) angeordnet ist.

4. Laserbelichtungsgerät nach Anspruch 1, dadurch gekennzeichnet, daß je eine Zusatzbelichtungseinrichtung (2, 2') vor und nach dem Laser-Schreibstrahl (24) vorhanden ist und daß nur jeweils eine der Zusatzbelichtungseinrichtungen (2, 2') während des Durchlaufs einer Druckform (4) durch das Laserbelichtungsgerät eingeschaltet ist.

5. Laserbelichtungsgerät nach einem der Ansprüche 1 bis 4, dadurch gekennzeichnet, daß in jeder der Zusatzbelichtungseinrichtungen (2; 2') die LED-Zeilenanordnung (8) aus zumindest zwei Reihen von Modulen (Dᵢ; Dᵢ') aus Leuchtdioden besteht, daß die LED-Zeilenanordnung (8) die unterhalb der Zusatzbelichtungseinrichtung (2; 2') vorbeibewegten Druckformen (4) ganzflächig mit 25 bis 35 % ihrer Leuchtstärke belichtet, daß die die LED-Zeilenanordnung (8) nach unten hin abdeckende Schreibe (6) eine Lichtstreuscheibe ist und daß die LED-Zeilenanordnung (8) in einem Leuchtstärke- bzw. Leuchtleistungsbereich von 0 bis 100 % regelbar ist.

6. Laserbelichtungsgerät nach Anspruch 5, dadurch gekennzeichnet, daß die LED-Zeilenanordnung (8) in einem Wellenlängenbereich von 565 ± 20 nm abstrahlt und daß die abgestrahlte Wellenlänge größer ist als die Wellenlänge für die bildmäßige Belichtung der Druckform.

7. Laserbelichtungsgerät nach Anspruch 5, dadurch gekennzeichnet, daß die LED-Zeilenanordnung (8) aus zueinander versetzten Reihen von LED-Modulen (Dᵢ; Dᵢ') besteht und daß das einzelne Modul (Dᵢ; Dᵢ') aus mehreren Leuchtdioden zusammengesetzt ist.

8. Laserbelichtungsgerät nach Anspruch 7, dadurch gekennzeichnet, daß das einzelne Modul vier Leuchtdioden LED enthält, die in Reihe geschaltet sind.

9. Laserbelichtungsgerät nach Anspruch 7, dadurch gekennzeichnet, daß jeweils zwei Module (D₁, D₁'; D₂, D₂'; ... Dₙ, Dₙ') in Reihe geschaltet sind und von einem Stromkreis aus je einem Transistor (T₁; T₂; ... Tₙ), regelbarem oder festen Widerstand (R₁; R₂; ... Rₙ) und einer gemeinsamen Stromquelle für alle Module, die eine Referenzspannung U_{ref} an die Basis der Transistoren liefert, gesteuert sind.

10. Laserbelichtungsgerät nach Anspruch 9, dadurch gekennzeichnet, daß die Basen aller Transistoren (T₁, T₂, ... Tₙ) parallel und alle Widerstände (R₁, R₂, ... Rₙ) zwischen den Emittern der Transistoren und einer Masse-Leitung parallel geschaltet sind.

11. Laserbelichtungsgerät nach Anspruch 9, dadurch gekennzeichnet, daß die Referenzspannung U_{ref} eine Gleich- oder eine Rechteckspannung mit einem Tastverhältnis 1:2 ist.

12. Laserbelichtungsgerät nach Anspruch 5, dadurch gekennzeichnet, daß ein Sensor (3) zur Messung der Leuchtstärke der LED-Zeilenanordnung (8) in der Zusatzbelichtungseinrichtung (2) vorhanden ist.

13. Laserbelichtungsgerät nach Anspruch 7, dadurch gekennzeichnet, daß die LED-Zeilenanordnung (8) aus einzelnen Segmenten (11) besteht, die mittels Steckkontakten (12) zu einer Platine (9) zusammengesteckt sind.

14. Laserbelichtungsgerät nach Anspruch 13, dadurch gekennzeichnet, daß die Segmente (11) unterschiedliche oder gleiche Längen aufweisen.

15. Laserbelichtungsgerät nach Anspruch 8 oder 9, dadurch gekennzeichnet, daß im Inneren des Gehäuses (14) als Sensor (3) eine Fotodiode auf der Platine (9) angeordnet ist.

## Claims

1. Laser exposure apparatus for printing-forms to be exposed in imagewise manner, with a laser, a beam splitter, a modulator (15), a beam widener (19), a polygonal mirror (20), a scanner lens (21), a reference mask (22) and a reflecting mirror (23), whereby at least one supplementary exposure device (2, 2') is present in the laser exposure apparatus (1), characterised in that said supplementary exposure device is arranged in a sealed housing (14) on one of the two sides of a laser writing beam (24) pertaining to the laser (15) and in that a series array of LEDs (8) provides the supplementary irradiation which emerges through a disc (6) in the underside of the housing (14) and impinges on the continuous printing-form (4).

2. Laser exposure apparatus according to Claim 1, characterised in that the supplementary exposure device (2) is positioned upstream of the laser writing beam (24) in the direction of movement of the printing-form (4) through the laser exposure apparatus.

3. Laser exposure apparatus according to Claim 1, characterised in that the supplementary exposure device (2') is positioned downstream of the laser writing beam (24) in the direction of movement of the printing-form (4) through the laser exposure apparatus.

4. Laser exposure apparatus according to Claim 1, characterised in that a supplementary exposure device (2, 2') is present both upstream and downstream of the laser writing beam (24) and in that, in each instance, only one of the supplementary exposure devices (2, 2') is switched on during the passage of a printing-form (4) through the laser exposure apparatus.

5. Laser exposure apparatus according to one of Claims 1 to 4, characterised in that in each of the supplementary exposure devices (2; 2') the series array of LEDs (8) consists of at least two rows of modules (Dᵢ; Dᵢ') of light-emitting diodes, in that the series array of LEDs (8) exposes the printing-forms (4) which are moved past below the supplementary exposure device (2; 2') over the whole surface with 25 to 35 % of its luminosity, in that the disc (6) covering the series array of LEDs (8) in the downward direction is a light-scattering disc and in that the series array of LEDs (8) is capable of being regulated in a range of luminosity or luminous power from 0 to 100 %.

6. Laser exposure apparatus according to Claim 5, characterised in that the series array of LEDs (8) radiates in a wavelength range of 565 ± 20 nm and in that the radiated wavelength is greater than the wavelength for imagewise exposure of the printing-form.

7. Laser exposure apparatus according to Claim 5, characterised in that the series array of LEDs (8) consists of rows of LED modules (Dᵢ; Dᵢ') which are offset in relation to one another and in that the individual module (Dᵢ; Dᵢ') is composed of several light-emitting diodes.

8. Laser exposure apparatus according to Claim 7, characterised in that the individual module contains four light-emitting diodes (LEDs) which are connected in series.

9. Laser exposure apparatus according to Claim 7, characterised in that, in each instance, two modules (D₁, D₁'; D₂, D₂'; ... Dₙ, Dₙ') are connected in series and are controlled by an electrical circuit consisting of, in each case, a transistor (T₁; T₂; ... Tₙ), an adjustable or fixed resistor (R₁; R₂; ... Rₙ) and a common current source for all modules which provides a reference voltage U_{ref} to the base of the transistors.

10. Laser exposure apparatus according to Claim 9, characterised in that the bases of all the transistors (T₁, T₂, ... Tₙ) are parallel and all the resistors (R₁, R₂ ..., Rₙ) are connected in parallel between the emitters of the transistors and an earth wire.

11. Laser exposure apparatus according to Claim 9, characterised in that the reference voltage U_{ref} is a d.c. voltage or a square-wave voltage with a mark-to-space ratio of 1:2.

12. Laser exposure apparatus according to Claim 5, characterised in that a sensor (3) for measuring the luminosity of the series array of LEDs (8) is present in the supplementary exposure device (2).

13. Laser exposure apparatus according to Claim 7, characterised in that the series array of LEDs (8) consists of individual segments (11) which are plugged together by means of plug contacts (12) to form a circuit board (9).

14. Laser exposure apparatus according to Claim 13, characterised in that the segments (11) have differing or equal lengths.

15. Laser exposure apparatus according to Claim 8 or 9, characterised in that a photodiode is arranged on the circuit board (9) by way of sensor (3) in the interior of the housing (14).

## Revendications

1. Appareil d'exposition au laser pour plaques d'impression à exposer de façon picturale, équipé d'un laser (15) d'un diviseur de faisceau (17), d'un modulateur (18), d'un élargisseur de faisceau (19), d'un miroir polygonal (20), d'une lentille d'analyse (21), d'un masque de référence (22) et d'un miroir de renvoi (23), dans lequel est prévu au moins un dispositif d'exposition auxiliaire (2, 2') dans l'appareil d'exposition au laser (1), caractérisé en ce que ce dispositif d'exposition auxiliaire est disposé dans un boîtier clos (14) sur un des deux côtés d'un rayon d'écriture laser (24) du laser (15) et en ce qu'un dispositif linéaire de diodes LED (8) délivre l'exposition auxiliaire, qui émerge à travers un disque (6) dans le côté inférieur du boîtier (14) et frappe la plaque d'impression en mouvement (4).

2. Appareil d'exposition au laser selon la revendication 1, caractérisé en ce que le dispositif d'exposition auxiliaire (2) est disposé selon la direction de déplacement de la plaque d'impression (4) dans le dispositif d'exposition au laser en amont du rayon d'écriture laser (24).

3. Appareil d'exposition au laser selon la revendication 1, caractérisé en ce que le dispositif d'exposition laser auxiliaire (2') est disposé selon la direction de déplacement de la plaque d'impression (4) à travers l'appareil d'exposition au laser en aval du rayon d'écriture laser (24).

4. Dispositif d'exposition au laser selon la revendication 1, caractérisé en ce que chaque dispositif d'exposition auxiliaire (2, 2') est disposé en amont et en aval du rayon d'écriture laser (24) et en ce que seulement un des dispositifs d'exposition auxiliaires (2, 2') est mis en marche durant le passage d'une plaque d'impression (4) à travers l'appareil d'exposition au laser.

5. Appareil d'exposition au laser selon l'une quelconque des revendications 1 à 4, caractérisé en ce que, dans chacun des dispositifs d'exposition auxiliaires (2, 2'), le dispositif linéaire de diodes LED (8) se composant d'au moins deux rangées de modules (Dᵢ ; Dᵢ') se compose de diodes électroluminescentes, en ce que le dispositif linéaire de diodes LED (8) qui expose des plaques d'impression (4) est placé au-dessous du dispositif d'exposition auxiliaire (2 ; 2') sur toute leur surface avec 25 à 35% de leur intensité lumineuse, en ce que le disque (6) recouvrant vers le bas le dispositif linéaire de diodes LED (8) est un disque de dispersion de lumière et en ce que le dispositif linéaire de diodes LED (8) peut être réglé en intensité lumineuse ou en puissance lumineuse de 0 à 100%.

6. Appareil d'exposition au laser selon la revendication 5, caractérisé en ce que le dispositif linéaire de diodes LED (8) rayonne dans une plage de longueurs d'onde de 565 ± 20 nm et en ce que la longueur d'onde rayonnée est supérieure à la longueur d'onde pour l'exposition picturale de la plaque d'impression.

7. Appareil d'exposition au laser selon la revendication 5, caractérisé en ce que le dispositif linéaire de diodes LED (8) se compose de rangées mutuellement décalées de modules LED (Dᵢ ; Dᵢ') et en ce que chaque module (Dᵢ ; Dᵢ') est constitué de plusieurs diodes électroluminescentes.

8. Appareil d'exposition au laser selon la revendication 7, caractérisé en ce que chaque module comporte quatre diodes luminescentes LED, montées en série.

9. Appareil d'exposition au laser selon la revendication 7, caractérisé en ce que deux modules respectifs (D₁, D₁' ; D₂, D₂';... Dₙ, Dₙ') sont montés en série et sont commandés par un circuit constitué chacun d'un transistor (T₁ ; T₂ ;...; Tₙ), d'une résistance réglable ou fixe (R₁ ; R₂ ; ...; Rₙ) et d'une source de courant commune pour tous les modules, qui délivre une tension de référence U_{ref} à la base des transistors.

10. Appareil d'exposition au laser selon la revendication 9, caractérisé en ce que les bases de tous les transistors (T₁, T₂,..., Tₙ) sont montés en parallèle et toutes les résistances (R₁, R₂,..., Rₙ) sont montés en parallèle entre les émetteurs des transistors et une ligne de masse.

11. Appareil d'exposition au laser selon la revendication 9, caractérisé en ce que la tension de référence U_{ref} est une tension continue ou une tension rectangulaire à rapport cyclique 1:2.

12. Appareil d'exposition au laser selon la revendication 5, caractérisé en ce qu'un capteur (3) est prévu en vue de la mesure de l'intensité lumineuse du dispositif linéaire de diodes LED (8) présentes dans le dispositif d'exposition auxiliaire (2).

13. Appareil d'exposition au laser selon la revendication 7, caractérisé en ce que le dispositif linéaire de diodes LED (8) se compose de différents segments (11), qui sont enfichés conjointement au moyen de fiches (12) sur une platine (9).

14. Appareil d'exposition au laser selon la revendication 13, caractérisé en ce que les segments (11) présentent des longueurs différentes ou identiques.

15. Appareil d'exposition au laser selon la revendication 8 ou 9, caractérisé en ce qu'à l'intérieur du boîtier (14) est disposée, sur la platine (9), une photodiode en tant que capteur (3).
